Europäisches Patentamt

European Patent Office

Office européen des brevets

(11) Publication number: **0 100 150**
A2

## EUROPEAN PATENT APPLICATION

(21) Application number: 83303748.4

(22) Date of filing: 29.06.83

(51) Int. Cl.³: **C 30 B 11/14**, C 30 B 29/52

(30) Priority: 28.07.82 US 402754

(43) Date of publication of application: 08.02.84
Bulletin 84/6

(84) Designated Contracting States: **BE CH DE FR GB IT LI SE**

(71) Applicant: **TRW INC., 23555 Euclid Avenue, Cleveland Ohio 44117 (US)**

(72) Inventor: **Cybulsky, Michael, 410 Fairground Boulevard, Canfield Ohio 44406 (US)**
Inventor: **Piwonka, Thomas S., 6429 Creekside Trail, Solon Ohio 44139 (US)**

(74) Representative: **Abble, Andrew Kenneth et al, A.A. THORNTON & CO. Northumberland House 303/306 High Holborn, London, WC1V 7LE (GB)**

(54) **Single crystal metal airfoil.**

(57) A single crystal metal airfoil is cast with a central axis of the airfoil skewed at a selected acute angle relative to the (001) direction of cubic unit cells of the metal crystal forming the airfoil. In order to obtain desired operating characteristics, the central axis of the airfoil may extend parallel to the (111) direction of cubic unit cells of the single crystal of metal forming the airfoil. In casting the article, longitudinally extending columnar grains are formed in a starter cavity. These grains have unit cells oriented with their (001) directions extending parallel to the central axis of the starter cavity. The molten metal is then solidified in a selector passage. A single crystal enters an airfoil mold cavity from the selector passage. This single crystal has cubic unit cells with (001), (010) and (100) directions in predetermined orientations. The central axis of the airfoil mold cavity is skewed at acute angles relative to the (001), (010) and (100) directions.

0100150

— \ —

SINGLE CRYSTAL METAL AIRFOIL

Background of the Invention

The present invention relates to the casting of a
single crystal airfoil having unit cells in a
predetermined orientation relative to a longitudinal
central axis of the airfoil.

Precast single crystal seeds have previously been used
to cast single crystal articles having a desired
crystallographic orientation. To accomplish this, a seed
having the desired crystallographic orientation is
selected. The seed may be precast, finished and its
orientation determined by Laue X-ray back reflection or
other methods. The seed is then placed at the bottom of
an article mold cavity and molten metal is poured against
the seed. The resulting casting will have a
crystallographic orientation which corresponds to the
crystallographic orientation of the seed. One example of
this technique is disclosed in U.S. Patent No. 3,139,653.

The casting of single crystal articles having a desired crystallographic orientation by using seed crystals has not yet been successful in the commercial production of articles, such as turbine engine components. The process of using a seed having a desired crystallographic orientation to effect the casting of an article having the same crystallographic orientation requires the maintenance of close thermal tolerances during the casting process. At the present time, it is doubtful that these thermal tolerances can be reproducibly achieved on an economical basis during casting with production size molds.

It has been suggested that a doubly-oriented single crystal casting could be obtained by using a pair of chill plates disposed at right angles to each other in the manner disclosed in U.S. Patent No. 3,572,419. According to this patent, intersecting columnar grain growths are used in an effort to obtain the desired crystallographic orientation. In addition, U.S. Patent No. 3,580,324 has suggested that a ceramic tube could be used in association with a pair of chill surfaces disposed at right angles relative to each other in order to obtain a double-oriented single crystal casting.

## Summary of the Present Invention

The present invention provides a single crystal airfoil having a central axis which is skewed at a selected acute angle relative to the [001] direction of cubic unit cells of the single crystal of metal forming the airfoil. The central axis of the airfoil may also be skewed at selected acute angles relative to the [010] and [100] directions of the cubic unit cells of the single crystal of metal forming the airfoil. In one specific instance, the central axis of the airfoil was parallel to the [111] direction of the cubic unit cells in order to obtain specific operating characteristics.

The airfoil is formed by a method which includes the steps of selecting an acute angle at which the central axis of the airfoil is to be skewed relative to the [001] direction of cubic unit cells of metal forming the airfoil. The acute angles at which the central axis of the airfoil is to be skewed relative to the [010] and [100] directions may also be selected. It is contemplated that the acute angles which are selected may be such as to result in the airfoil having a central axis which extends parallel to the [111] direction of the cubic unit cells of the single crystal of metal forming the airfoil. However, other orientations could be selected if desired.

A mold having an airfoil forming cavity and a starter cavity is provided. The starter cavity has a central axis which is skewed at the selected acute angle or angles relative to the central axis of the airfoil forming cavity. A crystal selector passage extends between the starter cavity and the airfoil forming cavity.

During the forming of the airfoil, molten metal is conducted into the starter cavity, crystal selector passage and airfoil forming cavity. The molten metal is solidified in the starter cavity to form a plurality of elongated metal crystals. The elongated metal crystals which are formed in the starter cavity have longitudinal axes which extend parallel to the central axis of the starter cavity and have unit cells oriented with their [001] directions skewed at the selected acute angle relative to the central axis of the airfoil forming cavity. The cubic unit cells of each elongated crystal have their [010] and [100] directions randomly oriented relative to the [010] and [100] directions of the cubic unit cells of the other elongated metal crystals in the starter cavity.

Molten metal is solidified in the selector passage and the airfoil forming cavity. The molten metal in the airfoil forming cavity solidifies as a single crystal with cubic cells oriented with a [001] direction parallel to the central axis of the starter cavity and skewed at the selected acute angle relative to the central axis of the airfoil forming cavity. The [010] and [100] directions of the cubic unit cells of the single crystal casting are also skewed at the selected angles relative to the central axis of the airfoil forming cavity. It is contemplated that it may be preferred to solidify the molten metal in the airfoil forming cavity as a single crystal with cubic unit cells oriented with a [111] direction parallel to the cental axis of the airfoil forming cavity.

Accordingly, it is an object of this invention to provide a new and improved method of producing an single crystal metal airfoil having cubic unit cells oriented with a [001] direction skewed at a selected angle relative to the central axis of the airfoil without using a seed crystal.

Another object of this invention is to provide a new and improved method of forming an airfoil by flowing molten metal into an airfoil forming cavity, a crystal selector passage and a starter cavity and solidifying the molten metal in the airfoil forming cavity as a single crystal with cubic unit cells oriented with a [001] direction parallel to the central axis of the starter cavity and skewed at a selected acute angle relative to the central axis of the airfoil forming cavity.

Another object of this invention is to provide a new and improved method as set forth in the foregoing object and wherein the solidifying of the molten metal in the airfoil forming cavity as a single crystal includes solidifying the metal with cubic unit cells oriented with a [111] direction parallel to the central axis of the airfoil forming cavity.

Another object of this invention is to provide a new and improved method of forming an airfoil by solidifying molten metal as a single crystal with cubic unit cells having [001], [010] and [100] directions skewed at selected acute angles relative to the central axis of the airfoil.

## Brief Description of the Drawings

The foregoing and other objects and features of the present invention will become more apparent upon a consideration of the following description taken in connection with the accompanying drawings wherein:

Fig. 1 is an illustration of an airfoil formed of a single crystal of metal with cubic unit cells oriented with a [111] direction parallel to the central axis of the airfoil;

Fig. 2 is a schematic illustration depicting a cubic unit cell and its [001], [010], [100] and [111] directions;

Fig. 3 is an illustration depicting the orientation of a cubic unit cell of the airfoil of Fig. 1; and

Fig. 4 is a fragmentary schematic illustration of a mold used to cast the airfoil of Fig. 1.

## Description of One Specific
## Preferred Embodiment of the Invention

### Airfoil

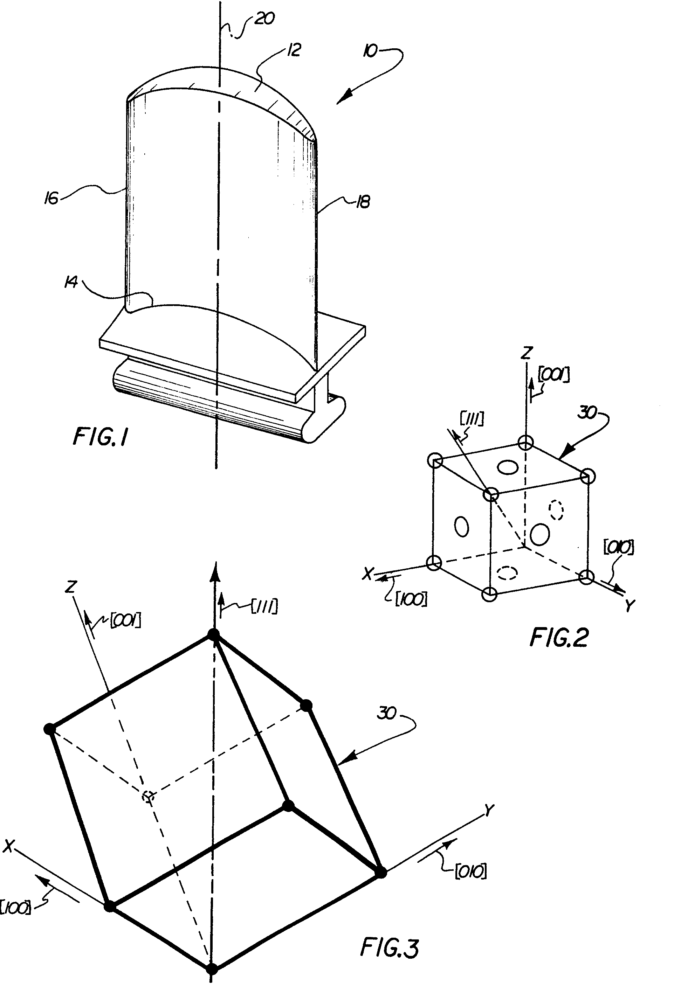

An airfoil 10 (Fig. 1) constructed in accordance with the present invention is formed of a single crystal of a nickel-chrome superalloy having unit cells of a face centered cubic construction. Although the airfoil 10 could be formed of many different nickel-chrome alloys, the airfoil was formed of the commercially available nickel-chrome alloy MAR-M 247.

The single crystal airfoil 10 is intended to be used in a gas turbine engine and includes a tip portion 12 and a root portion 14. Leading and trailing edge portions 16 and 18 extend between the tip and root portions 12 and 14. The airfoil 10 has a central axis 20 which is disposed midway between the leading and trailing edges 16 and 18 and extends through the tip and root portions 12 and 14.

Unit Cell

The unit cell 30 (see Fig. 2) is the fundamental building block of the single crystal airfoil 10. The unit cell 30 has an atomic arrangement which, when repeated in three dimensions, gives the total structure of the single crystal which forms the airfoil 10. The unit cell 30 has a face-centered cubic configuration which consists of an atom at each cube corner and one at the center of each face as depicted schematically in Fig. 2.

The orientation within the unit cell 30 is specified in terms of its co-ordinates relative to orthogonal X, Y and Z axes. When specifying directions in a unit cell, the notation [XYZ] is used to indicate the direction of a line from the origin to a point, the co-ordinates of which are X, Y and Z. By custom, brackets are utilized and fractional coordinates are avoided.

A direction along one of the edges of the cubic cell would also be parallel to one of the three axes. Thus, a direction parallel to the X axis would be referred to as the [100] direction (see Fig. 2), a direction parallel to the Y axis would be referred to as the [010] direction and a direction parallel to the Z axis would be referred to as the [001] direction. Crystals having vertical unit cell axes are said to have a [001] orientation, reflecting the convention of denoting the vertical axis as Z. A single crystal airfoil in which the Z axis of a unit cell is parallel to the central axis 20 is commonly referred to as having unit cells of the [001] orientation.

Although the airfoil 10 could have cubic unit cells with many different orientations, the airfoil 10 has unit cells with a [111] orientation. The [111] direction of a cubic unit cell extends through diagonally opposite corners of the cube (see Fig. 2). One of these corners is located at the origin, that is, at the intersection of the X, Y and Z axes. The [111] direction extends at an acute angle of 54.7 degrees to the [001] direction and Z axis. In addition, the [111] direction extends at an acute angle of 45 degrees to the [010] and [100] directions and the Y and X axes.

Since the cubic unit cells of the single crystal airfoil 10 are oriented in the [111] direction, the unit cube 30 is oriented relative to the airfoil 10 in the manner shown in Fig. 3. Thus, the [111] direction is parallel to the central axis 20 of the airfoil 10. The [100], [010] and [001] directions and X, Y and Z axes are skewed at acute angles relative to the [111] direction in the manner shown in Fig. 3.

Airfoils such as turbine engine blades and vanes have previously been produced with a [001] orientation (see U.S. Patent No. 3,494,709). When cubic unit cells of an airfoil have the [001] orientation, the side surfaces or faces of the unit cells lie either perpendicular or parallel to the longitudinal central axis 20 of the airfoil 10. By virtue of its low Young modulus, this orientation is recognized as superior from the standpoint of thermal fatigue resistance. However, other orientations offer possibilities of improved operating characteristics for the operating conditions found in a specific engine.

In cubic crystals, the [111] orientation provides the highest value of Young's modulus. At ambient temperature for nickel, this value is approximately 44,000,000 psi versus approximately 18,000,000 psi for a [001] orientation. High creep strength has also been reported for the [111] orientation as measured by creep rates and stress rupture lines at elevated temperatures on tests performed using individual crystals of nickel-base superalloys.

Depending upon the alloy and the specific test condition of stress and temperature, various orientations other than the [001] or [111] orientation may be preferred depending upon the vibration characteristics desired for the airfoil. However, difficulty has been encountered in the past in producing single crystal airfoils with other than the [001] orientation on a production basis.

Method of Forming the Airfoil

In accordance with a feature of the present invention, a single crystal airfoil 10 having a [111] orientation is cast by using a starter cavity in combination with a crystal selector. The crystal selector allows only a single crystal having a [111] direction in a predetermined orientation to enter an airfoil mold cavity. The airfoil mold cavity has a center line which is disposed parallel to the predetermined spatial orientation of the [111] direction of the cubic unit cells forming the single crystal which enters the airfoil forming cavity from the crystal selector. When it is desired to have an airfoil with an orientation which is different from the [111] orientation, the selected orientation of the central axis of the airfoil forming cavity is different.

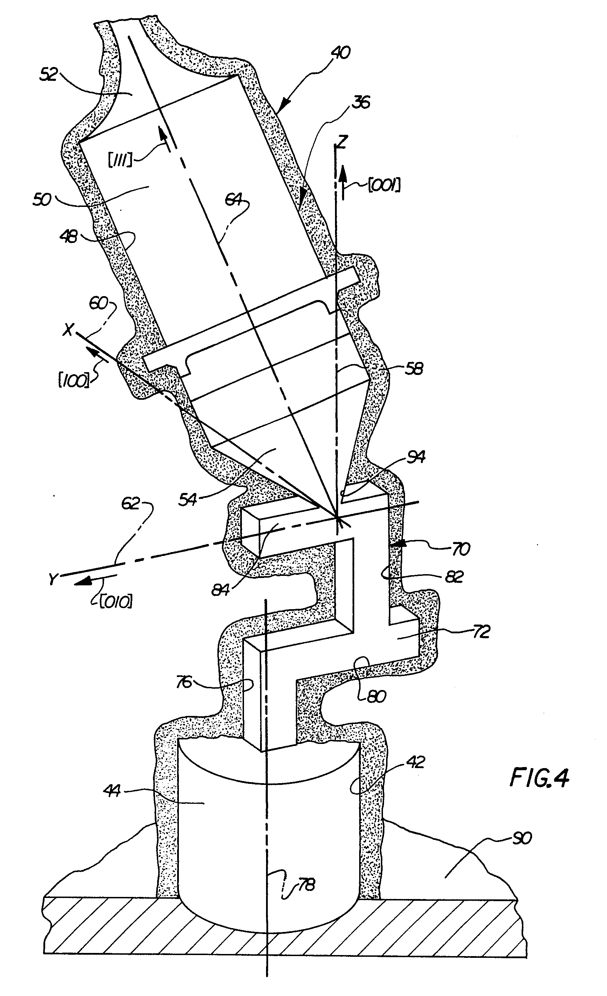

A casting 36 (see Fig. 4) from which the airfoil 10 is formed is made in a ceramic mold 40. The one piece ceramic mold 40 is formed by dipping a wax pattern in a ceramic mold material having a composition generally

similar to the mold composition disclosed in U.S. Patent 4,066,116. The one piece mold includes a starter cavity 42 in which a starter section 44 of the casting 36 is formed. The mold 40 also has an article or airfoil forming cavity 48 in which a single crystal airfoil casting 50 is formed. The single crystal airfoil casting 50 is trimmed to remove a sprue or entrance section 52 and a lower or base section 54 to form the airfoil 10 of Fig. 1.

The airfoil forming cavity 48 has a vertical or Z axis 58 (Fig. 4) which extends parallel to the [001] direction of the cubic unit cells 30 (Fig. 2) of the airfoil casting 50. The airfoil forming cavity 48 also has X and Y axes 60 and 62 (Fig. 4) which extend parallel to the [100] and [010] directions of the cubic unit cells 30 of the airfoil casting 50. A central axis 64 of the airfoil forming cavity 48 is skewed at selected acute angles relative to the X, Y and Z axes (Fig. 4).

In order to form the airfoil 10 with a [111] orientation, the airfoil forming cavity 48 is oriented with its central axis 64 skewed at acute angles relative to the X, Y and Z axes. The central axis 64 is skewed relative to the Z axis at an angle of 54.7 degrees. This is the same acute angle at which the [111] direction is skewed relative to the [001] direction of the cubic unit cell 30 in Fig. 2. The central axis 64 is skewed relative to the X and Y axes 60 and 62 at an angle of 45 degrees. This is the same acute angle at which the [111] direction is skewed relative to the [100] and [010] directions of the cubic unit cell 30 in Fig. 2. If it were desired to have the unit cells of the single crystal airfoil casting 50 at an orientation other than the [111] orientation, the angle at which the central axis 64 of the airfoil forming cavity 48 is skewed relative to the X, Y and/or Z axes would be modified to correspond to the desired angular orientation of the unit cell relative to the airfoil.

A selector cavity 70 extends between the starter cavity 42 and mold cavity 48. The selector cavity 70 has a plurality of sections which extend at right angles and which form a cast right angle selector piece 72. Thus, the selector cavity 70 has an entry or initial section 76 which extends vertically upwardly from an upper side of the cylindrical starter cavity 42. The starter cavity 42 has a vertical central axis which is coincident with the central axis of the entry section 76.

A lower transverse section 80 of the selector cavity 70 extends horizontally outwardly from the upright initial section 76. A second upright section 82 of the selector cavity 70 connects the lower transverse section 80 with a horizontally extending upper transverse section 84. The horizontal upper and lower transverse sections 80 and 84 extend parallel to the Y axis 62 while the initial section 76 and connector section 82 extend parallel to the central axis 78 of the starter cavity and the Z axis 58. The central axis 78 of the starter cavity 42 is skewed at an acute angle relative to the central axis 64 of the airfoil mold cavity 48. The central axis 64 of the airfoil mold cavity 48 is coincident with the central axis 20 of an airfoil 10 formed in the mold cavity.

Casting Operation

When the airfoil 10 is to be cast in the mold 40, the mold is preheated and an open end of the mold is positioned on a chill plate 90. Molten metal is then poured into the mold 40 and flows downwardly through the sprue or entry 52. The molten metal flows downwardly through the airfoil forming cavity 48, selector cavity 70 and starter cavity 42 to the chill 90.

The chill 90 causes the molten metal in the starter cavity 42 to solidify as a relatively large number of elongated columnar grains. Each of the elongated single crystal grains extends vertically upwardly from the upper side surface of the chill 90 to the upper end of the starter cavity 42. The elongated single crystal grains have central axes which are parallel to the vertical central axis 78 of the starter cavity 42.

The vertically extending grains in the starter cavity 42 have unit cells with an [001] direction which extends parallel to the Z axis 58. The other axes of the unit cells of each of the single crystal columnar grains are randomly oriented relative to the corresponding axes of unit cells of other columnar grains. Thus, the [100] and [010] and [111] directions of each unit cell (see Fig. 2) of one columnar grain are randomly oriented relative to the corresponding directions of the unit cells of another columnar grain in the starter cavity 42.

A few of the columnar grains grow into the initial section 76 of the selector cavity 70 from the starter cavity 42. As the molten metal in the lower transverse section 72 of the selector cavity 70 solidifies, the grains which are more favorably oriented for transverse or horizontal growth, that is in the [010] direction parallel to the Y axis 62, tend to predominate and crowd out less favorably oriented grains. During continued solidification of the molten metal in the selector cavity 70, the grains grow upwardly into the connector section 82. During this upward growth, the single crystal grains which are most favorably oriented in the [001] direction parallel to the Z axis 58 predominate and tend to crowd out other grains. Finally, the metal in the upper transverse section 84 of the selector cavity begins to solidify.

As the metal in the upper transverse section 84 solidifies, a single crystal or grain having a horizontal [010] direction which is parallel to the Y axis 62 and a vertical [001] direction which is parallel to the Z axis 58 will grow through the entrance 94 to the airfoil forming cavity 48. The cubic unit cells of the single crystal which grows into the airfoil mold cavity 48 will have a vertical [001] direction and a horizontal [010] direction extending parallel to the horizontal central axis of the upper transverse section 84 of the selector cavity 70. Since the orientations of two of the directions, that is [001] and [010] directions are determined, the orientation of the horizontal axis 60 and [100] direction are also determined.

By properly selecting the orientation of the airfoil mold cavity 48 relative to the upper transverse section 84 of the selector cavity 70, the airfoil cast in the cavity 48 can have any desired crystallographic orientation. In the present instance, it was desired to form the airfoil 10 cast with a [111] orientation. Therefore, the airfoil mold cavity 48 was oriented relative to the selector cavity 70 with the central axis 64 of the airfoil mold cavity skewed at 54.7 degrees from the [001] direction and Z axis 58 in the manner shown for the cubic unit cell 30 of Fig. 2. The central axis 64 (Fig. 4) of the airfoil mold cavity 48 extends at 45 degrees to the [010] and [001] directions and the Y and X axes 62 and 60. This results in the airfoil casting 50 having a [111] orientation with a central axis coincident with the mold cavity axis 64.

When the excess metal is removed from the airfoil casting 50, the result is the airfoil 10 (Fig. 1) having a [111] orientation. Of course, if it was desired to form a single crystal airfoil with unit cells having an orientation other than the [111] orientation, the central axis 64 of the airfoil forming cavity 48 would be skewed at different angles relative to the X, Y and Z axes. By properly selecting the spatial orientation of the mold cavity axis 64, the [001], [010], [100] and [111] directions of the cubic unit cells of a single crystal airfoil can be chosen to maximize the operating characteristics of an airfoil.

In view of the foregoing it is apparent that the present invention provides a single crystal airfoil 10 having a central axis 20 which is skewed at a selected acute angle relative to the [001] direction of cubic unit cells 30 of the single crystal of metal forming the airfoil. The central axis 20 of the airfoil 10 is also skewed at selected acute angles relative to the [010] and [100] directions of the cubic unit cells of the single crystal of metal forming the airfoil. In the specific embodiment described, the central axis 20 of the airfoil 10 was parallel to the [111] direction of the cubic unit cells in order to obtain specific operating characteristics.

The airfoil 10 is formed by a method which includes the steps of selecting an acute angle at which the central axis of the airfoil is to be skewed relative to the [001] direction of cubic unit cells of metal forming the airfoil. In the illustrated embodiment of the invention, the selected angle was 54.7 degrees. The acute angles at which the central axis 20 of the airfoil 10 is to be skewed relative to the [010] and [100] directions may also be selected. In the illustrated embodiment, these angles were both selected as being 45 degrees. However, it is contemplated that the acute angles which are selected may be such as to result in the airfoil 10 having a central axis 20 which extends parallel to any desired direction of the cubic unit cells 30 of the single crystal of metal forming the airfoil.

A mold 40 having an airfoil forming cavity 48 and a starter cavity 42 is provided. The starter cavity 42 has a central axis 78 which is skewed at the selected acute angle relative to the central axis of the airfoil forming cavity 48. In the illustrated embodiment of the invention, the vertical starter cavity axis 78 was skewed at an angle of 54.7 degrees relative to the central axis 64 of the airfoil forming cavity 48. A crystal selector passage 70 extends between the starter cavity 42 and the airfoil forming cavity 48.

During the forming of the airfoil, molten metal is conducted into the starter cavity 42, crystal selector passage 70 and airfoil forming cavity 48. The molten metal is solidified in the starter cavity 42 to form a plurality of elongated metal crystals. The elongated metal crystals which are formed in the starter cavity 42 have longitudinal axes which extend parallel to the central axis 78 of the starter cavity and have unit cells oriented with their [001] directions skewed at the selected acute angle, that is 54.7 degrees, relative to the central axis 64 of the airfoil forming cavity 48. The cubic unit cells 30 of each elongated crystal have their [010] and [100] directions randomly oriented relative to the [010] and [100] directions of the cubic unit cells of the other elongated metal crystals in the starter cavity 42.

Molten metal is solidified in the selector passage 70 and the airfoil forming cavity 48. The molten metal in the airfoil forming cavity 48 solidifies as a single crystal with cubic cells oriented with a [001] direction parallel to the central axis 78 of the starter cavity 42 and skewed at the selected acute angle, that is 54.7 degrees, relative to the central axis 64 of the airfoil forming cavity 48. The [010] and [100] directions of the cubic unit cells of the single crystal casting are also skewed at the selected angles, that is 45 degrees, relative to the central axis 64 of the airfoil forming cavity 48.

CLAIMS

1.    A method of casting as a single crystal of metal
an airfoil having leading and trailing edge portions with
a central axis disposed between the leading and trailing
edge portions, said method comprising the steps of
providing a mold having an airfoil forming cavity, a
starter cavity having a central axis which is skewed at an
acute angle relative to a central axis of the airfoil
forming cavity and a crystal selector passage extending
between the starter cavity and the airfoil forming cavity,
flowing molten metal into the airfoil forming cavity,
crystal selector passage and starter cavity, solidifying
the molten metal in the starter cavity, said step of
solidifying the molten metal in the starter cavity
including forming a plurality of elongated metal crystals
having longitudinal axes which are parallel to the central
axis of the starter cavity and which are skewed at an
acute angle relative to the central axis of the airfoil
forming cavity, solidifying the molten metal in the
selector passage, said step of solidifying the molten
metal in the selector passage including growing at least
one of the elongated metal crystals from the starter
cavity into the selector passage, and solidifying the
molten metal in the airfoil forming cavity as a single crystal of metal with cubic unit cells oriented with a [111] direction parallel to the central axis of the airfoil forming cavity, said step of solidifying the molten metal in the airfoil forming cavity including forming the airfoil with its central axis coincident with the central axis of the airfoil forming cavity and skewed at an acute angle relative to the central axis of the starter cavity.

2. A method as set forth in claim 1 wherein said step of solidifying the molten metal in the airfoil forming cavity includes the step of growing a single crystal of metal from the selector passage into the airfoil forming cavity.

3. A method as set forth in claim 1 wherein said step of solidifying the molten metal in the starter cavity includes forming each of the elongated metal crystals with unit cells oriented with their [111] direction in a random orientation relative to the [111] directions of unit cells of other elongated metal crystals in the starter cavity.

4.    A method of casting as a single crystal of metal an airfoil having leading and trailing edge portions with a central axis disposed between the leading and trailing edge portions, said method comprising the steps of selecting acute angles at which the central axis of the airfoil is to be skewed relative to the [001], [010], and [100] directions of cubic unit cells of a single crystal of metal forming the airfoil, thereafter, providing a mold having an airfoil forming cavity having a configuration corresponding to the configuration of the airfoil, a starter cavity and a crystal selector passage extending between the starter cavity and the airfoil forming cavity, flowing molten metal into the airfoil forming cavity, crystal selector passage and starter cavity, solidifying the molten metal in the starter cavity, said step of solidifying the molten metal in the starter cavity including forming a plurality of elongated metal crystals having parallel longitudinal axes, said step of forming a plurality of elongated metal crystals including forming each of the elongated metal crystals with cubic unit cells having their [001] direction parallel to the [001] directions of the cubic unit cells of the other elongated metal crystals and their [010] and [100] directions randomly oriented relative to the [010] and [100] directions of the cubic unit cells of the other elongated metal crystals, solidifying the molten metal in the
selector passage, and solidifying the molten metal in the
airfoil forming cavity to form an airfoil as a single
crystal of metal with cubic unit cells having [001], [010]
and [100] directions all skewed at the selected acute
angles relative to the central axis of the airfoil.


5.    A method as set forth in claim 4 wherein said
step of solidifying the molten metal in the mold cavity
includes the step of solidifying the molten metal to form
the airfoil as a single crystal with cubic unit cells
having a [111] direction parallel to the central axis of
the airfoil.

FIG.1

FIG.2

FIG.3

0100150

FIG.4